(19) Europäisches Patentamt / European Patent Office / Office européen des brevets

(11) **EP 3 311 596 B1**

(12) **EUROPÄISCHE PATENTSCHRIFT**

(45) Veröffentlichungstag und Bekanntmachung des Hinweises auf die Patenterteilung:
**05.08.2020 Patentblatt 2020/32**

(21) Anmeldenummer: **16728880.2**

(22) Anmeldetag: **02.06.2016**

(51) Int Cl.:
*H04W 4/46* (2018.01)   *H04B 1/3822* (2015.01)
*H03G 3/30* (2006.01)   *H04B 1/40* (2015.01)

(86) Internationale Anmeldenummer:
**PCT/EP2016/062502**

(87) Internationale Veröffentlichungsnummer:
**WO 2016/206940 (29.12.2016 Gazette 2016/52)**

(54) **KOMPENSATIONSVORRICHTUNG, INSBESONDERE CHIPSET-UNABHÄNGIGE KOMPENSATIONSVORRICHTUNG FÜR EINE C2C-KOMMUNIKATION**

COMPENSATION DEVICE, IN PARTICULAR A CHIPSET-INDEPENDENT COMPENSATION DEVICE FOR A C2C COMMUNICATION

DISPOSITIF DE COMPENSATION, EN PARTICULIER DISPOSITIF DE COMPENSATION INDÉPENDANT D'UN JEU DE PUCES POUR UNE COMMUNICATION C2C

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **22.06.2015 DE 102015211413**

(43) Veröffentlichungstag der Anmeldung:
**25.04.2018 Patentblatt 2018/17**

(73) Patentinhaber: **Continental Automotive GmbH 30165 Hannover (DE)**

(72) Erfinder:
• **MORHART, Christian**
  **93096 Köfering (DE)**
• **OWEN, Richard**
  **93049 Regensburg (DE)**

(56) Entgegenhaltungen:
**WO-A1-2014/177556    DE-T2- 69 912 001**
**US-A1- 2004 145 494    US-A1- 2006 165 022**
**US-A1- 2010 226 291    US-B1- 7 289 775**

**Beschreibung**

Die Erfindung betrifft ein Verfahren und eine Kompensationsvorrichtung für ein als Fahrzeug-zu-Fahrzeug-Kommunikation zu sendendes Signal.

Zur "Car2Car"- Kommunikation (Kommunikation zwischen Fahrzeugen) an sich existieren schon einige Ansätze, wie z.B. in DE 10 2008 009 330 A1. US 2004/145494 A1 und US 2006/165022 A1 zeigen Verstärker.

Eine Aufgabe der Erfindung ist es, eine "Car2Car"- Kommunikation zu optimieren. Die Aufgabe wird jeweils durch die Gegenstände der unabhängigen Patentansprüche gelöst. Einige besonders vorteilhafte Ausgestaltungen der Erfindung sind in den Unteransprüchen und der Beschreibung angegeben. Ausgestaltungen der Erfindung können eine verbesserte "Car2Car"- Kommunikation ermöglichen, insbesondere hinsichtlich einer Steuerung der Sendeleistung für ein Distributed Congestion Control (=DCC =Verteilte-Verkehrs-Stau -Steuerung) Signal.

Weitere Merkmale und Vorteile einiger vorteilhafter Ausgestaltungen der Erfindung ergeben sich aus der nachfolgenden Beschreibung von Ausführungsbeispielen der Erfindung anhand der Zeichnung. Dabei zeigt zur Veranschaulichung von einigen möglichen Ausgestaltungen der Erfindung, jeweils vereinfachend schematisch:

Fig. 1    eine Kompensationsvorrichtung mit einem Kanal,

Fig. 2    eine weitere Kompensationsvorrichtung mit zwei Kanälen,

Fig. 3    eine Car2Car-Kommunikation.

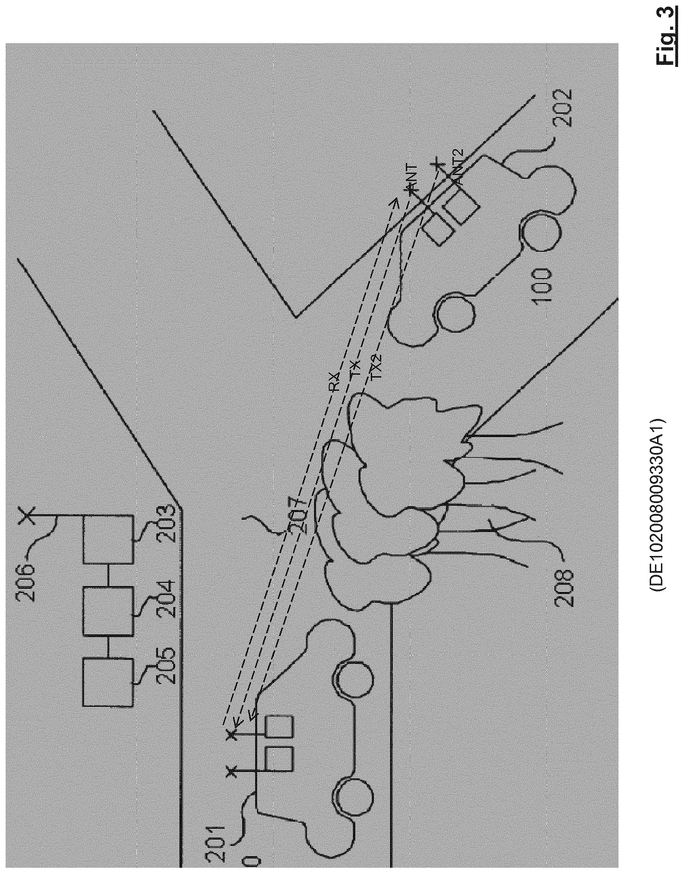

Fig. 3 zeigt eine sogenannte "Car2Car"-Kommunikation (= Fahrzeug-Fahrzeug-Kommunikation oder Kommunikation zwischen Fahrzeugen) wie auch teilweise in DE102008009330A1, wobei eine Kommunikation zwischen Fahrzeugen und eine Kommunikation zwischen Fahrzeugen und Infrastruktur (wie Baken und/oder Mautsystemen) dargestellt ist.

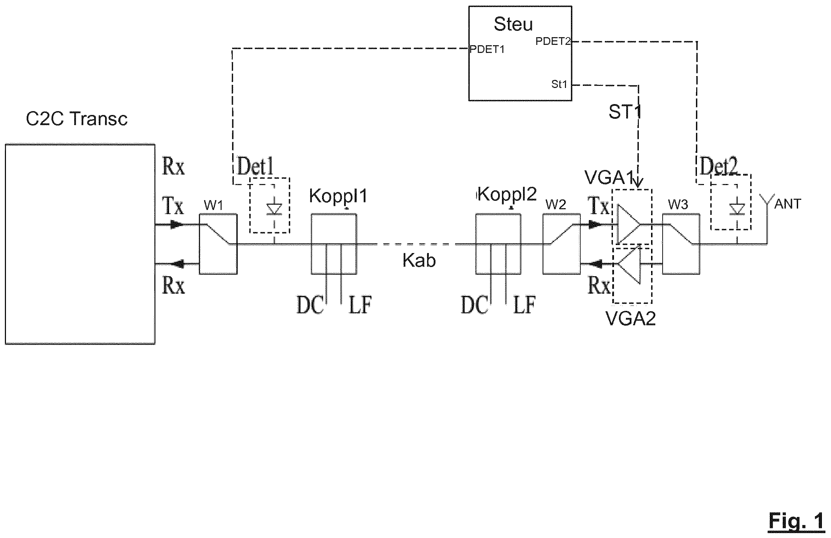

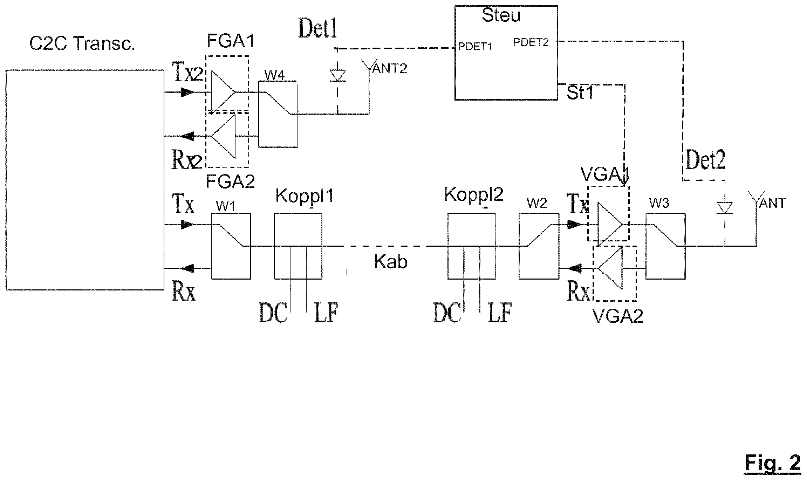

Fig. 3 zeigt eine Car2Car-Kommunikation, bei der ein Fahrzeug 202 (z.B. auch mit einer Ausgestaltung gemäß Fig. 1 oder Fig. 2) an ein weiteres Fahrzeug 201 und/oder mehrere Fahrzeuge und/oder (Maut- und/oder Stauerfassungs- und/oder Baken-) Infrastruktur 206 mit einer Antenne ANT als Car2Car-Kommunikation ein Sendesignal TX sendet, und ggf. (z.B. auch mit einer Ausgestaltung gemäß Fig. 2) mit einer weiteren Antenne ANT2 als Car2Car-Kommunikation ein weiteres Sendesignal TX2 sendet, und/oder ggf. auch ein Empfangssignal RX von z.B. einem weiteren Fahrzeug 201 als Car2Car-Kommunikation empfängt.

Bei einer C2C Kommunikation ist für eine Distributed Congestion Control (DCC) eine genaue Steuerung oder Regelung der (gesendeten) Ausgangsleistung vorteilhaft. Aufgrund von Kabelverlusten bei der Frequenz (z.B. 5.9 GHz) eines zu sendenden Signals ist eine Kompensationsvorrichtung für insbesondere Konfigurationen mit von ihrer Ansteuerung entfernten Antennen zweckmäßig. In einem Standardfall kann eine solche Kompensationsvorrichtung von dem Transceiver angesteuert werden, der Informationen über die erforderliche zu sendende Ausgangsleistung hat. Da manche Transceiver keine Unterstützung für eine Fernsteuerung eines Kompensators haben können, können erfindungsgemäße Ausgestaltungen von Vorteil sein, die z .B. Techniken zur Ansteuerung einer Ausgangsleistung (output power) einer Kompensationsvorrichtung ohne Transceiver Feedback ermöglichen können.

Nach zumindest intern bekannten Ansätzen steuert ein C2C Transceiver eine RF Ausgangsleisung (RF output power) eines C2C Geräts durch direktes Detektieren der RF Leistung selbst oder durch Detektieren einer analogen Spannung die sich auf eine solche Leistung bezieht. Da eine Ausgangsleistung (output power) selbst in einem Transceiver bekannt sein, kann er diese zwei Level von Leistungen vergleichen und die Ausgangsleistung (output power level) geeignet justieren. Der erste Fall könnte schwierig zu implementieren sein hinsichtlich eines Designs einer Kompensationsvorrichtung, weil er eine zusätzliche koaxiale Verbindung zur Kompensationsvorrichtung benötigen könnte, die zweite Option könnte einen Transceiver benötigen, der einen AD-Wandler für die Detektion einer analogen Spannung zur Verfügung hat, und eine dritte Option wäre die Detektion dieses Levels (dieser Leistung) mit einem externen Microcontroller mit einer Übertragung dieses Wertes an eine Anwendungsschicht (application layer), wobei diese Variante problematisch sein könnte hinsichtlich einer ggf. erforderlichen Adaption eines C2C Software Stacks. Einige der nachfolgenden erfindungsgemäßen Ausgestaltungen einer Kompensationsvorrichtung könnten vorteilhaft sein durch eine Transceiver-unabhängige Technik einer Leistungs-Detektion und Regulation.

Eine Ausgestaltung eines erfindungsgemäßen neuen Ansatzes kann unabhängig von der Transceiver Struktur sein. Dies kann z.B. erreicht werden, indem die RF (Hochfrequenz) Leistung bestimmt wird vor einer Einspeisung einer Eingangsleistung (input power) in ein (Koaxial-) Kabel sowie an einer Antenne seitens einer Kompensationsvorrichtung. Mit einem ersten Detektor (z.B. Det1) kann die (beabsichtigte) Ausgangsleistung (output power) auf der Transceiver Seite gemessen werden, mit einer zweiten Detektionseinrichtung (Det2) kann eine (tatsächliche) Ausgangsleistung (output power) an einer Kompensationsvorrichtung gemessen werden, und die Differenz kann ein Indikator sein für die Kabelverluste die dann kompensiert werden können.

Dabei kann gelten:

$$\Delta P = DeltaP = PDet1 - PDet2$$

$$\Delta P = DeltaP = LKab + Gfixed + GVariabel$$

Fig. 1 und Fig. 2 zeigen jeweils einige Details jeweils einer Ausgestaltung einer erfindungsgemäßen Kompensationsvorrichtung (mit z.B. Det1 und/oder Det2 und/oder Steu und/oder VGA1) und Schaltung für ein als Fahrzeug-zu-Fahrzeug-Kommunikation zu sendendes (Sende-)Signal Tx, mit einem Kanal W1, Koppl1, Kab, Koppl2, W2, VGA, W3 von einem Fahrzeug-zu-Fahrzeug-Kommunikations-Transceiver "C2C-Transc" zu einer Antenne ANT (und/oder ANT2) hin,

- mit einer ersten Sendeleistungs-Detektionseinrichtung Det1, die (Det1) mit einem (dem einzigen oder einem von mehreren) Sendeausgang Tx; Tx2 des Fahrzeug-zu-Fahrzeug-Kommunikations-Transceivers C2C-Transc verbunden ist, um eine erste Leistung PDet1 zu detektieren,
- mit einer zweiten Sendeleistungs-Detektionseinrichtung Det2, die Det2 mit einer Antenne ANT verbunden ist, um eine zweite Leistung PDet2 zu detektieren,
- mit einer (beliebig implementierbaren, vereinfacht dargestellten) Steuerungseinrichtung Steu zur Bildung einer Differenz ΔP zwischen dem Wert der detektierten ersten Leistung PDet1 und dem Wert der detektierten zweiten Leistung PDet2 und zur Bildung eines Steuersignals St1 für einen Verstärker VGA1,
- mit einem (z.B. VGA-) Verstärker VGA1 mit einem durch das Steuersignal St1 einstellbaren Verstärkungsfaktor (der größer oder gleich oder auch kleiner als 1 (dann ist der Verstärker ein Dämpfungsglied, z.B. in Form eines VGA) sein kann).

Fig. 1 zeigt zu einigen Ausgestaltungen der Erfindung eine Kompensationsvorrichtung mit einem Kanal und/oder einer Antenne ANT und/oder mit den beiden Sendeleistungs-Detektionseinrichtungen Det1 und Det2 im selben Kanal (zwischen C2CTransc und hinsichtlich Det1, Det2 derselben Antenne ANT).

Fig. 1 zeigt eine Kompensationsvorrichtung bei der die erste Sendeleistungs-Detektionseinrichtung Det1, mit einem Sendeausgang Tx des Fahrzeug-zu-Fahrzeug-Kommunikations-Transceivers C2C-Transc verbunden ist, um eine erste Leistung PDet1 zu detektieren, welcher Sendeausgang Tx mit dem Kanal W1, Koppl1, Kab, Koppl2, W2, VGA, W3 von einem Fahrzeug-zu-Fahrzeug-Kommunikations-Transceiver C2C-Transceiver zu einer Antenne ANT hin verbunden ist, mit welchem Kanal W1, Koppl1, Kab, Koppl2, W2, VGA, W3 und/oder mit welcher Antenne ANT auch die zweite Sendeleistungs-Detektionseinrichtung Det2 (hier an der Weiche W3 und an der Antenne ANT befindlich) verbunden ist.

Die Leistung und/oder Verstärkung des (VGA-) Verstärkers VGA1 mit einem durch das Steuersignal St1 einstellbaren Verstärkungsfaktor wird hier abhängig von der Differenz DeltaP oder ΔP (DeltaP = ΔP = PDet1 - PDet2) einer von der (mit einem Sendeausgang Tx (z.B. beim Messen) verbundenen) ersten Sendeleistungs-Detektionseinrichtung Det1 bestimmten Leistung PDet1 und von der (mit einer Antenne ANT verbunden) zweiten Sendeleistungs-Detektionseinrichtung Det2 bestimmten Leistung PDet2 gesteuert. Z.B. kann DeltaP = ΔP dabei der Summe aus einem Verlust LKab im Kabel Kab und der Leistung (oder gain) durch Verstärkung in einem Verstärker (z.B. in C2CTransc oder FGA1) mit einem fixen Verstärkungsfaktor und der Leistung (und/oder gain) GVariabel durch Verstärkung in einem Verstärker (z.B. VGA1) mit einem ansteuerbaren Verstärkungsfaktor sein (DeltaP = ΔP = LKab + Gfixed +GVariabel).

Fig. 2 zeigt zu einigen Ausgestaltungen der Erfindung eine Kompensationsvorrichtung mit zwei Kanälen, wobei zwei Antennen ANT, ANT2 und/oder die zwei Sendeleistungs-Detektionseinrichtungen Det1 und Det2 in verschiedenen Kanälen (zwischen C2CTransc und je einer Antenne ANT, ANT2) angeordnet sein können. Fig. 2 zeigt eine Kompensationsvorrichtung bei der ein (neben einem Kanal wie z.B. etwa in Fig. 1) weiterer Kanal FGA1 / FGA2, W4, ANT2 von einem Fahrzeug-zu-Fahrzeug-Kommunikations-Transceiver (= C2C-Transceiver, im folgenden auch Transceiver genannt) zu einer weiteren Antenne ANT2 hin z.B. eine Sende-Empfangs-Weiche W4 und/oder einen (FGA-)Verstärker FGA1 für das zu sendende Sendesignal Tx und/oder einen Verstärker FGA2 für ein zu empfangendes Empfangssignal Rx aufweist.

In Fig. 2 mit einem Zwei-Kanal-Aufbau ist eine Antenne ANT2 direkt (also z.B. nur über Verstärker FGA1, FGA2 und/oder eine Sende-Empfangsweiche W4 und/oder ohne ein (z.B. koaxiales) Kabel Kab) mit einem Transceiver C2CTransc verbunden, während eine weiteren Antenne ANT über eine Kompensationsvorrichtung (mit z.B. einem Verstärker mit steuerbarem Verstärkungsfaktor im Sendepfad für ein zu sendendes Signal Tx) mit einem Transceiver C2CTransc verbunden ist. In diesem Fall wird die output Leistung der direkt verbundenen Antenne ANT2 direkt (an / nahe dieser) detektiert (mit Det1) und als Sollwert für die andere Antenne ANT /und damit für den steuerbaren Verstärkungsfaktor von VGA1) verwendet.

Die Koppler Koppl1, Koppl2 (im Kanal) an den beiden Enden des (z.B. koaxialen) Kabels Kab können (z.B. als Frequenzmultiplex und/oder durch Addition) dazu ausgebildet sein, RF (also z.B. Hochfrequenz wie z.B. zu sendende und/oder zu empfangende C2C Signale) und/oder Gleichspannung (DC) Signale und/oder niederfrequente Signals (LF) über dasselbe Kabel Kab zu übertragen, z.B. auch in zwei Richtungen (z.B. im Zeitmultiplex und/oder Frequenzmultiplex).

Die Leistung des (VGA-) Verstärkers VGA1 mit einem durch das Steuersignal St1 einstellbaren Verstärkungsfaktor wird hier abhängig von der Differenz DeltaP = $\Delta P$ (DeltaP = $\Delta P$ = PDet1 - PDet2 oder $\Delta P$ = PDet1 - PDet2) einer mit der mit an einem Sendeausgang Tx2 (z.B. beim Messen) verbundenen ersten Sendeleistungs-Detektionseinrichtung Det1 bestimmten Leistung PDet1 und der mit einer (mit einem anderen Sendeausgang Tx über einen Kanal verbundenen) Antenne ANT verbunden zweiten Sendeleistungs-Detektionseinrichtung Det2 bestimmten Leistung PDet2 gesteuert. Auch hier kann z.B. kann DeltaP = $\Delta P$ dabei die Summe aus einem Verlust LKab im Kabel Kab und der Leistung durch Verstärkung in mindestens einem Verstärker (z.B. in C2CTransc oder FGA1) mit einem festen Verstärkungsfaktor und der Leistung GVariabel durch Verstärkung in mindestens einem Verstärker (z.B. VGA1) mit ansteuerbarem Verstärkungsfaktor sein (DeltaP = $\Delta P$ = LKab + Gfixed +GVariabel).

Ausgestaltungen der Erfindung können ggf. unabhängig von einer Transceiver Struktur sein. Die Sendeleistung oder Empfangsleistung (RF power) für ein Signal (insb. Tx; oder Tx undTx2) kann bestimmt werden vor dem Zuführen der input Leistung in ein (z.B. koaxiales) Kabel Kab (mit Det1) und seitens (mit Det2) einer Antenne (ANT) - und zwar mit Detektionen Dt1, Dt2 im gleichen (Fig. 1) Kanal (Sendepfad) oder (Fig. 2) verschiedenen Kanälen (= z.B. insb. Sendepfaden).

Mit einem ersten Detektor Dt1 kann eine (beabsichtigte) output Leistung auf der Seite des Transceivers CsCTransc gemessen werden. Mit einem zweiten Detektor Det2 kann eine tatsächliche output Leistung seitens des Kompensators und/oder einer Antenne ANT gemessen werden. Die Differenz $\Delta P$ der beiden (mit Det1, Det2) bestimmten Leistungen kann ein Maß für eine Verlustleistung im Kabel Kab (zwischen C2CTransc und einer Antenne ANT) sein, welche Verlustleistung ganz oder teilweise kompensiert werden soll, z.B. durch Änderung des Verstärkungsfaktors eines Verstärkers (VGA1) mit einem von einer (die Differenz zur Bildung eines Steuersignals St1 berücksichtigenden) Steuerung erzeugten Steuersignal St1.

Eine Kompensationsvorrichtung kann insbesondere einen Verstärker mit einem durch das Steuersignal (St1) einstellbaren Verstärkungsfaktor (VGA) aufweisen.

Mit einem Variable Gain Amplifier und/oder VGA und/oder Spannungsgesteuerten Verstärker kann ein Verlust insbesondere im Kabel kompensiert werden; dabei kann ein fixer Verstärkungsfaktor oder fixed gain ohne Einfluss auf das Kabel Kab verbleiben.

Nach Ausgestaltungen der Erfindung kann dies auch nicht-instantan erfolgen: Die output Leistung kann (mit z.B. Det1) für das selbe (als Signal Tx / Tx2 zu sendende) Paket am Transceiver C2CTransc gemessen werden wie seitens der Kompensationsvorrichtung (insb. des VGA1), aber eine Anpassung einer output Leistung (durch VGA1) könnte erst mit dem zeitlich nächsten (als Signal Tx / Tx2 zu sendende) Paket wirksam werden. Ferner kann es erforderlich sein, eine berechnete Differenz DeltaP = $\Delta P$ (DeltaP = $\Delta P$ = PDet1 - PDet2) irgendwie von der Seite des der Kompensationsvorrichtung (insb. des VGA1 und/oder der Messeinrichtung Det2) zur Seite des Transceiver C2CTransc oder vice versa in anderer Richtung zu übertragen, z.B. je nachdem wo eine Steuerung ist, die die Differenz auswertet und ein Steuersignal St1 für einen Verstärker VGA1 bildet; hierfür könnte ein zusätzliches Kommunikations-Interface erforderlich sein, z.B. als Kabel oder über das vorhandene Kael Kab auf einer anderen Frequenz als der für zu sendende und/oder zu empfangene Signale benutzten etc.

Ein Vorteil von Ausgestaltungen der Erfindung kann darin liegen, dass eine Kompensationsvorrichtung bzw. ein Kompensationsvorrichtungs-Interface unabhängig von einem gewählten Transceiver sein kann. In einem möglichen Standard-Fall kann ein Transceiver eine Kompensationsvorrichtung unterstützen durch Detektieren und Anpassen der Ausgangsleistung. Ein Vorteil von Ausgestaltungen der Erfindung kann in einer unabhängigen Detektion der gewünschten Ausgangsleistung (output power) mit einer zweiten Detektionseinrichtung insbesondere vor einem Koaxialkabel (zwischen Koaxialkabel und Transceiver) liegen. Ferner kann eine Ausgangsleistungs-Kalibrierung in einer Kompensationsvorrichtung anstatt im Transceiver vorgesehen sein.

**Patentansprüche**

1. Kompensationsvorrichtung für ein als Fahrzeug-zu-Fahrzeug-Kommunikation zu sendendes Signal (Tx),

     - mit mindestens einem Kanal (W1, Koppll, Kab, Koppl2, W2, VGA, W3) von einem Fahrzeug-zu-Fahrzeug-Kommunikations-Transceiver (C2C-Transc) zu mindestens einer Antenne (ANT) hin,
     - mit einer ersten Sendeleistungs-Detektionseinrichtung (Det1), die (Det1) mit einem Sendeausgang (Tx; Tx2) des Fahrzeug-zu-Fahrzeug-Kommunikations-Transceivers (C2C-Transc)

verbunden (W1) ist, um eine erste Leistung (PDet1) zu detektieren,

- mit einer zweiten Sendeleistungs-Detektionseinrichtung (Det2), die mit der mindestens einen Antenne (ANT) verbunden ist, um eine zweite Leistung (PDet2) zu detektieren,
- mit einer Steuerungseinrichtung (Steu) zur Bildung einer Differenz (ΔP) zwischen dem Wert der detektierten ersten Leistung (PDet1) und dem Wert der detektierten zweiten Leistung (PDet2) zur Bildung eines Steuersignals (St1),
- mit einem Verstärker (VGA1) mit durch das Steuersignal (St1) einstellbarem Verstärkungsfaktor, der (VGA1) zwischen dem Fahrzeug-zu-Fahrzeug-Kommunikations-Transceiver (C2C-Transc) und der mindestens einen Antenne (ANT) angeordnet ist,

wobei der einstellbare Verstärker (VGA, VGA1) im Kanal (W1, Koppll, Kab, Koppl2, W2, VGA, W3) von einem Fahrzeug-zu-Fahrzeug-Kommunikations-Transceiver (C2C-Transc) zu der mindestens einen Antenne (ANT) hin zwischen Kabel (Kab) und Antenne (ANT) angeordnet ist.

2. Kompensationsvorrichtung nach Anspruch 1,
**dadurch gekennzeichnet, dass**
die erste Sendeleistungs-Detektionseinrichtung (Det1), mit einem Sendeausgang (Tx) des Fahrzeug-zu-Fahrzeug-Kommunikations-Transceivers (C2C-Transc) verbunden ist, um eine erste Leistung (PDet1) zu detektieren, welcher Sendeausgang (Tx) mit dem Kanal (W1, Koppll, Kab, Koppl2, W2, VGA, W3) von einem Fahrzeug-zu-Fahrzeug-Kommunikations-Transceiver (C2C-Transceiver) zu einer Antenne (ANT) hin verbunden ist, mit welchem Kanal (W1, Koppll, Kab, Koppl2, W2, VGA, W3) und/oder mit welcher Antenne (ANT) auch die zweite Sendeleistungs-Detektionseinrichtung (Det2) verbunden ist. (Fig. 1)

3. Kompensationsvorrichtung nach Anspruch 1,
**dadurch gekennzeichnet, dass**
die erste Sendeleistungs-Detektionseinrichtung (Det1), mit einem Sendeausgang (Tx2) des Fahrzeug-zu-Fahrzeug-Kommunikations-Transceivers (C2C-Transc) verbunden ist, um eine erste Leistung (PDet1) zu detektieren, welcher Sendeausgang (Tx2) mit einem anderen Kanal (FGA1, FGA2, W4, ANT2) von einem Fahrzeug-zu-Fahrzeug-Kommunikations-Transceiver (C2C-Transceiver) zu einer Antenne (ANT2) hin verbunden ist, als der Kanal (W1, Koppll, Kab, Koppl2, W2, VGA, W3) mit welchem die zweite Sendeleistungs-Detektionseinrichtung (Det2) verbunden ist, und/oder mit einer anderen Antenne (Ant2) verbunden ist, als die zweite Sendeleistungs-Detektionseinrichtung (Det2). (Fig. 2)

4. Kompensationsvorrichtung nach einem der vorhergehenden Ansprüche, **dadurch gekennzeichnet, dass**
die erste Sendeleistungs-Detektionseinrichtung (Det1) mit einem Sendeausgang (Tx) des Fahrzeug-zu-Fahrzeug-Kommunikations-Transceivers (C2C-Transc) entweder direkt oder über eine Weiche (W1) und /oder Verstärker (FGPA1) verbunden ist, um eine erste Leistung (PDet1) zu detektieren.

5. Kompensationsvorrichtung nach einem der vorhergehenden Ansprüche, **dadurch gekennzeichnet, dass**
der Kanal (W1, Koppll, Kab, Koppl2, W2, VGA, W3) von dem Fahrzeug-zu-Fahrzeug-Kommunikations-Transceiver (C2C-Transceiver) zu einer Antenne (ANT) hin eine erste Sende-Empfangs-Weiche (W1) und/oder eine erste Kopplungseinrichtung (Koppll) und/oder eine insbesondere koaxiale Kabelverbindung (Kab) und/oder eine zweite Kopplungseinrichtung (Koppl2) und/oder einen Verstärker (VGA1) für das zu sendende Sendesignal (Tx) und/oder eine zweite Sende-Empfangs-Weiche (W2) und/oder einen Verstärker (VGA2) für ein zu empfangendes Sendesignal (Rx) und/oder eine dritte Sende-Empfangs-Weiche (W3) aufweist.

6. Kompensationsvorrichtung nach einem der vorhergehenden Ansprüche, **dadurch gekennzeichnet, dass**
ein weiterer Kanal (FGA1, FGA2, W4, ANT2) von einem Fahrzeug-zu-Fahrzeug-Kommunikations-Transceiver (C2C-Transceiver) zu einer weiteren Antenne (ANT2) hin eine Sende-Empfangs-Weiche (W4) und/oder einen Verstärker (FGA1) für das zu sendende Sendesignal (Tx) und/oder einen Verstärker (FGA2) für ein zu empfangendes Empfangssignal (Rx) aufweist,
insbesondere mit mindestens einem FGA-Verstärker (FGA1, FGA2). (Fig. 2)

7. Kompensationsvorrichtung nach einem der vorhergehenden Ansprüche, **dadurch gekennzeichnet, dass**
der Verstärker (VGA1) mit einem durch das Steuersignal (St1) einstellbaren Verstärkungsfaktor (VGA) ein VGA-Verstärker ist.

8. Kompensationsvorrichtung nach einem der vorhergehenden Ansprüche, **dadurch gekennzeichnet, dass** die Kompensationsvorrichtung (Steu, Det1, Det2, VGA1) und/oder die mindestens eine Antenne (ANT, ANT2) für einen Einbau in ein Fahrzeug (202) ausgebildet ist und/oder in einem Fahrzeug (202) eingebaut ist.

9. Kompensationsvorrichtung nach einem der vorhergehenden Ansprüche, **dadurch gekennzeichnet, dass** ein im Rahmen von einer oder als Fahrzeug-zu-Fahrzeug-Kommunikation zu sendendes Sendesignal (Tx) ein Verkehrs-Stau-Steuerungs-Signal und/oder Distributed Congestion Control (DCC) Signal ist und/oder eine Frequenz von 5.9 GHz aufweist.

10. Kompensationsvorrichtung nach einem der vorhergehenden Ansprüche, **dadurch gekennzeichnet, dass** die Steuerungseinrichtung (Steu) dazu ausgebildet ist, dass in Abhängigkeit von der Höhe der Differenz ($\Delta$P) zwischen dem Wert der detektierten ersten Leistung (PDet1) und dem Wert der detektierten zweiten Leistung (PDet2) durch ein Steuersignal (St1) der einstellbare Verstärkungsfaktor (VGA) des Verstärkers (VGA1) eingestellt wird.

11. Kompensationsvorrichtung nach einem der vorhergehenden Ansprüche,
   **dadurch gekennzeichnet, dass**
   sich die erste Sendeleistungs-Detektionseinrichtung (Det1), und die zweite Sendeleistungs-Detektionseinrichtung (Det2) entweder auf unterschiedlichen Seiten eines Kabels (Kab) in einem Kanal (W1, Koppl1, Kab, Koppl2, W2, VGA, W3) befinden (Fig. 1),
   oder in unterschiedlichen Kanälen (FGA1, FGA2, W4, ANT2); W1, Koppl1, Kab, Koppl2, W2, VGA, W3) befinden (Fig. 2).

12. Verfahren zur Fahrzeug-zu-Fahrzeug-Kommunikation durch ein zu sendendes Signal (Tx),

   - wobei das zu sendende Signal (Tx) über einen Kanal (W1, Koppl1, Kab, Koppl2, W2, VGA, W3) von einem Fahrzeug-zu-Fahrzeug-Kommunikations-Transceiver (C2C-Transc) zu einer Antenne (ANT) hin übertragen wird,
   - wobei mit einer ersten Sendeleistungs-Detektionseinrichtung (Det1), die (Det1) mit einem Sendeausgang (Tx; Tx2) des Fahrzeug-zu-Fahrzeug-Kommunikations-Transceivers (C2C-Transc) verbunden ist, eine erste Leistung (PDet1) detektiert wird,
   - wobei mit einer zweiten Sendeleistungs-Detektionseinrichtung (Det2), die (Det2) mit der Antenne (ANT) verbunden ist, eine zweite Leistung (PDet2) detektiert wird,
   - wobei mit einer Steuerungseinrichtung (Steu) eine Differenz ($\Delta$P) zwischen dem Wert der detektierten ersten Leistung (PDet1) und dem Wert der detektierten zweiten Leistung (PDet2) bestimmt wird und ein Steuersignal (St1) in Abhängigkeit hiervon gebildet wird,
   - wobei durch das Steuersignal (St1) ein einstellbarer Verstärkungsfaktor (VGA) eines Verstärkers (VGA1) eingestellt wird,
   - wobei der
   einstellbare Verstärker (VGA, VGA1) im Kanal (W1, Koppl1, Kab, Koppl2, W2, VGA, W3) von einem Fahrzeug-zu-Fahrzeug-Kommunikations-Transceiver (C2C-Transc) zu mindestens einer Antenne (ANT) hin zwischen Kabel (Kab) und Antenne (ANT) angeordnet ist.

**Claims**

1. Compensation device for a signal (Tx) to be transmitted as vehicle-to-vehicle communication,

   - having at least one channel (W1, Koppl1, Kab, Koppl2, W2, VGA, W3) from a vehicle-to-vehicle communication transceiver (C2C-Transc) to at least one antenna (ANT),
   - having a first transmission power detection apparatus (Det1), which (Det1) is connected (W1) to a transmission output (Tx; Tx2) of the vehicle-to-vehicle communication transceiver (C2C-Transc) in order to detect a first power (PDet1),
   - having a second transmission power detection apparatus (Det2), which is connected to the at least one antenna (ANT) in order to detect a second power (PDet2),
   - having a control apparatus (Steu) for calculating a difference ($\Delta$P) between the value of the detected first power (PDet1) and the value of the detected second power (PDet2) in order to form a control signal (St1),

- having an amplifier (VGA1) with a gain factor able to be set by the control signal (St1), which (VGA1) is arranged between the vehicle-to-vehicle communication transceiver (C2C-Transc) and the at least one antenna (ANT),

wherein the settable amplifier (VGA, VGA1) is arranged between the cable (Kab) and the antenna (ANT) in the channel (W1, Koppl1, Kab, Koppl2, W2, VGA, W3) from a vehicle-to-vehicle communication transceiver (C2C-Transc) to the at least one antenna (ANT).

2. Compensation device according to Claim 1,
   **characterized in that**
   the first transmission power detection apparatus (Det1) is connected to a transmission output (Tx) of the vehicle-to-vehicle communication transceiver (C2C-Transc) in order to detect a first power (PDet1), which transmission output (Tx) is connected to the channel (W1, Koppl1, Kab, Koppl2, W2, VGA, W3) from a vehicle-to-vehicle communication transceiver (C2C-Transceiver) to an antenna (ANT), to which channel (W1, Koppl1, Kab, Koppl2, W2, VGA, W3) and/or to which antenna (ANT) the second transmission power detection apparatus (Det2) is also connected. (Fig. 1)

3. Compensation device according to Claim 1,
   **characterized in that**
   the first transmission power detection apparatus (Det1) is connected to a transmission output (Tx2) of the vehicle-to-vehicle communication transceiver (C2C-Transc) in order to detect a first power (PDet1), which transmission output (Tx2) is connected to a channel (FGA1, FGA2, W4, ANT2) from a vehicle-to-vehicle communication transceiver (C2C-Transceiver) to an antenna (ANT2) different from the channel (W1, Koppl1, Kab, Koppl2, W2, VGA, W3) to which the second transmission power detection apparatus (Det2) is connected,
   and/or is connected to an antenna (Ant2) different from the second transmission power detection apparatus (Det2). (Fig. 2)

4. Compensation device according to one of the preceding claims, **characterized in that**
   the first transmission power detection apparatus (Det1) is connected to a transmission output (Tx) of the vehicle-to-vehicle communication transceiver (C2C-Transc) either directly or via a switch (W1) and/or amplifier (FGPA1) in order to detect a first power (PDet1).

5. Compensation device according to one of the preceding claims, **characterized in that**
   the channel (W1, Koppl1, Kab, Koppl2, W2, VGA, W3) from the vehicle-to-vehicle communication transceiver (C2C-Transceiver) to an antenna (ANT) has a first transceiver switch (W1) and/or a first coupling apparatus (Koppl1) and/or an in particular coaxial cable connection (Kab) and/or a second coupling apparatus (Koppl2) and/or an amplifier (VGA1) for the transmission signal (Tx) to be transmitted and/or a second transceiver switch (W2) and/or an amplifier (VGA2) for a transmission signal (Rx) to be received and/or a third transceiver switch (W3).

6. Compensation device according to one of the preceding claims, **characterized in that**
   a further channel (FGA1, FGA2, W4, ANT2) from a vehicle-to-vehicle communication transceiver (C2C-Transceiver) to a further antenna (ANT2) has a transceiver switch (W4) and/or an amplifier (FGA1) for the transmission signal (Tx) to be transmitted and/or an amplifier (FGA2) for a reception signal (Rx) to be received, in particular having at least one FGA amplifier (FGA1, FGA2). (Fig. 2)

7. Compensation device according to one of the preceding claims, **characterized in that**
   the amplifier (VGA1) with a gain factor (VGA) able to be set by the control signal (St1) is a VGA amplifier.

8. Compensation device according to one of the preceding claims, **characterized in that**
   the compensation device (Steu, Det1, Det2, VGA1) and/or the at least one antenna (ANT, ANT2) is/are designed for installation in a vehicle (202) and/or is/are installed in a vehicle (202).

9. Compensation device according to one of the preceding claims, **characterized in that**
   a transmission signal (Tx) to be transmitted in the context of or as vehicle-to-vehicle communication is a traffic congestion control signal and/or distributed congestion control (DCC) signal and/or has a frequency of 5.9 GHz.

10. Compensation device according to one of the preceding claims, **characterized in that**
    the control apparatus (Steu) is designed such that the settable gain factor (VGA) of the amplifier (VGA1) is set by a control signal (St1) depending on the extent of the difference ($\Delta P$) between the value of the detected first power (PDet1) and the value of the detected second power (PDet2).

11. Compensation device according to one of the preceding claims, **characterized in that**
the first transmission power detection apparatus (Det1) and the second transmission power detection apparatus (Det2) are situated either on different sides of a cable (Kab) in a channel (W1, Koppl1, Kab, Koppl2, W2, VGA, W3) (Fig. 1) or are situated in different channels (FGA1, FGA2, W4, ANT2; W1, Koppl1, Kab, Koppl2, W2, VGA, W3) (Fig. 2).

12. Method for vehicle-to-vehicle communication by way of a signal (Tx) to be transmitted,

- wherein the signal (Tx) to be transmitted is transmitted via a channel (W1, Koppl1, Kab, Koppl2, W2, VGA, W3) from a vehicle-to-vehicle communication transceiver (C2C-Transc) to an antenna (ANT),
- wherein a first transmission power detection apparatus (Det1), which (Det1) is connected to a transmission output (Tx; Tx2) of the vehicle-to-vehicle communication transceiver (C2C-Transc), is used to detect a first power (PDet1),
- wherein a second transmission power detection apparatus (Det2), which (Det2) is connected to the antenna (ANT), is used to detect a second power (PDet2),
- wherein a control apparatus (Steu) is used to determine a difference ($\Delta$P) between the value of the detected first power (PDet1) and the value of the detected second power (PDet2) and to form a control signal (St1) depending thereon,
- wherein the control signal (St1) is used to set a settable gain factor (VGA) of an amplifier (VGA1),
- wherein the settable amplifier (VGA, VGA1) is arranged between the cable (Kab) and the antenna (ANT) in the channel (W1, Koppl1, Kab, Koppl2, W2, VGA, W3) from a vehicle-to-vehicle communication transceiver (C2C-Transc) to least one antenna (ANT).

**Revendications**

1. Arrangement de compensation pour un signal (Tx) à émettre sous la forme d'une communication de véhicule à véhicule,

- comprenant au moins un canal (W1, Koppl1, Kab, Koppl2, W2, VGA, W3) d'au moins un émetteur-récepteur de communication de véhicule à véhicule (C2C-Transc) vers au moins une antenne (ANT),
- comprenant un premier dispositif de détection de puissance d'émission (Det1), le (Det1) étant relié (W1) à une sortie d'émission (Tx ; Tx2) de l'émetteur-récepteur de communication de véhicule à véhicule (C2C-Transc) afin de détecter une première puissance (PDet1),
- comprenant un deuxième dispositif de détection de puissance d'émission (Det2), qui est relié à l'au moins une antenne (ANT) afin de détecter une deuxième puissance (PDet2),
- comprenant un dispositif de commande (Steu) destiné à former une différence ($\Delta$P) entre la valeur de la première puissance (PDet1) détectée et la valeur de la deuxième puissance (PDet2) détectée en vue de former un signal de commande (St1),
- comprenant un amplificateur (VGA1) ayant un gain réglable par le signal de commande (St1), le (VGA1) étant disposé entre l'émetteur-récepteur de communication de véhicule à véhicule (C2C-Transc) et l'au moins une antenne (ANT),

l'amplificateur (VGA, VGA1) réglable étant disposé dans le canal (W1, Koppl1, Kab, Koppl2, W2, VGA, W3) d'un émetteur-récepteur de communication de véhicule à véhicule (C2C-Transc) vers l'au moins une antenne (ANT) entre le câble (Kab) et l'antenne (ANT).

2. Arrangement de compensation selon la revendication 1, **caractérisé en ce que** le premier dispositif de détection de puissance d'émission (Det1) est relié à une sortie d'émission (Tx) de l'émetteur-récepteur de communication de véhicule à véhicule (C2C-Transc) afin de détecter une première puissance (PDet1), laquelle sortie d'émission (Tx) est reliée au canal (W1, Koppl1, Kab, Koppl2, W2, VGA, W3) d'un émetteur-récepteur de communication de véhicule à véhicule (C2C-Transc) vers une antenne (ANT), canal (W1, Koppl1, Kab, Koppl2, W2, VGA, W3) ou antenne (ANT) avec lequel/laquelle est également relié le deuxième dispositif de détection de puissance d'émission (Det2). (Fig. 1)

3. Arrangement de compensation selon la revendication 1, **caractérisé en ce que** le premier dispositif de détection de puissance d'émission (Det1) est relié à une sortie d'émission (Tx2) de l'émetteur-récepteur de communication de véhicule à véhicule (C2C-Transc) afin de détecter une première puissance (PDet1), laquelle sortie d'émission (Tx2) est reliée à un autre canal (FGA1, FGA2, W4, ANT2) d'un émetteur-récepteur de communication de véhicule à véhicule (C2C-Transc) vers une antenne (ANT2) que le canal (W1, Koppl1, Kab, Koppl2, W2, VGA, W3) avec lequel est relié le deuxième dispositif de détection de puissance d'émission (Det2) et/ou avec une autre antenne (ANT2) que le deuxième dispositif de détection de puissance d'émission (Det2). (Fig. 2)

4. Arrangement de compensation selon l'une des revendications précédentes, **caractérisé en ce que** le premier dispositif de détection de puissance d'émission (Det1) est relié à une sortie d'émission (Tx) de l'émetteur-récepteur de communication de véhicule à véhicule (C2C-Transc) soit directement, soit par le biais d'un filtre séparateur (W1) et/ou un amplificateur (FGPA1) afin de détecter une première puissance (PDet1).

5. Arrangement de compensation selon l'une des revendications précédentes, **caractérisé en ce que** le canal (W1, Koppl1, Kab, Koppl2, W2, VGA, W3) de l'émetteur-récepteur de communication de véhicule à véhicule (C2C-Transc) vers une antenne (ANT) possède un premier filtre séparateur d'émission/réception (W1) et/ou un premier dispositif de couplage (Koppl1) et/ou une liaison par câble (Kab) notamment coaxiale et/ou un deuxième dispositif de couplage (Koppl2) et/ou ou un amplificateur (VGA1) pour le signal d'émission à émettre (Tx) et/ou un deuxième filtre séparateur d'émission/réception (W2) et/ou un amplificateur (VGA2) pour un signal d'émission à recevoir (Rx) et/ou un troisième filtre séparateur d'émission/réception (W3).

6. Arrangement de compensation selon l'une des revendications précédentes, **caractérisé en ce qu'**un canal supplémentaire (FGA1, FGA2, W4, ANT2) d'un émetteur-récepteur de communication de véhicule à véhicule (C2C-Transc) vers une antenne supplémentaire (ANT2) possède un filtre séparateur d'émission/réception (W4) et/ou un amplificateur (FGA1) pour le signal d'émission à émettre (Tx) et/ou un amplificateur (FGA2) pour un signal d'émission à recevoir (Rx), notamment avec au moins un amplificateur FGA (FGA1, FGA2). (Fig. 2)

7. Arrangement de compensation selon l'une des revendications précédentes, **caractérisé en ce que** l'amplificateur (VGA1) est un amplificateur ayant un gain (VGA) réglable par le signal de commande (St1).

8. Arrangement de compensation selon l'une des revendications précédentes, **caractérisé en ce que** l'arrangement de compensation (Steu1, Det1, Det2, VGA1) et/ou l'au moins une antenne (ANT, ANT2) est conçu(e) pour une installation dans un véhicule (202) et/ou est installé(e) dans un véhicule (202).

9. Arrangement de compensation selon l'une des revendications précédentes, **caractérisé en ce qu'**un signal d'émission (Tx) à émettre dans le cadre ou sous la forme d'une communication de véhicule à véhicule est un signal de commande d'encombrement de trafic et/ou un signal de régulation de l'encombrement distribué (DCC) et/ou possède une fréquence de 5,9 GHz.

10. Arrangement de compensation selon l'une des revendications précédentes, **caractérisé en ce que** le dispositif de commande (Steu) est configuré de sorte que le gain (VGA) de l'amplificateur (VGA1) est réglé par un signal de commande (St1) en fonction de l'importance de la différence ($\Delta$P) entre la valeur de la première puissance détectée (PDet1) et la valeur de la deuxième puissance détectée (PDet2).

11. Arrangement de compensation selon l'une des revendications précédentes, **caractérisé en ce que** le premier dispositif de détection de puissance d'émission (Det1) et le deuxième dispositif de détection de puissance d'émission (Det2) se trouvent soit sur des côtés différents d'un câble (Kab) dans un canal (W1, Koppl1, Kab, Koppl2, W2, VGA, W3) (Fig. 1), soit dans des canaux différents (FGA1, FGA2, W4, ANT2) ; (W1, Koppl1, Kab, Koppl2, W2, VGA, W3) (Fig. 2).

12. Procédé de communication de véhicule à véhicule par un signal à émettre (Tx),

- le signal à émettre (Tx) étant transmis par le biais d'un (W1, Koppl1, Kab, Koppl2, W2, VGA, W3) d'un émetteur-récepteur de communication de véhicule à véhicule (C2C-Transc) vers une antenne (ANT),
- une première puissance (PDet1) étant détectée avec un premier dispositif de détection de puissance d'émission (Det1), le (Det1) étant relié à une sortie d'émission (Tx ; Tx2) de l'émetteur-récepteur de communication de véhicule à véhicule (C2C-Transc),
- une deuxième puissance (PDet2) étant détectée avec un deuxième dispositif de détection de puissance d'émission (Det2), le (Det2) étant relié à l'antenne (ANT),

- une différence (ΔP) entre la valeur de la première puissance (PDet1) détectée et la valeur de la deuxième puissance (PDet2) détectée étant déterminée avec un dispositif de commande (Steu) et un signal de commande (St1) étant formé en fonction de celle-ci,
- un gain réglable (VGA) d'un amplificateur (VGA1) étant réglé par le signal de commande (St1)
- l'amplificateur (VGA, VGA1) réglable étant disposé dans le canal (W1, Koppl1, Kab, Koppl2, W2, VGA, W3) d'un émetteur-récepteur de communication de véhicule à véhicule (C2C-Transc) vers au moins une antenne (ANT) entre le câble (Kab) et l'antenne (ANT).

**Fig. 1**

EP 3 311 596 B1

Fig. 2

**Fig. 3**

(DE102008009330A1)

**IN DER BESCHREIBUNG AUFGEFÜHRTE DOKUMENTE**

**In der Beschreibung aufgeführte Patentdokumente**

- DE 102008009330 A1
- US 2004145494 A1
- US 2006165022 A1